# EUROPÄISCHE PATENTSCHRIFT

(11) **EP 2 462 628 B1**
(45) Veröffentlichungstag und Bekanntmachung des Hinweises auf die Patenterteilung: **29.05.2013**
(21) Anmeldenummer: 10737926.5
(22) Anmeldetag: 03.08.2010
(51) Int. Cl.: H01L 31/048, H01L 31/18, B32B 27/28, B32B 37/12

(54) **VERFAHREN ZUR HERSTELLUNG VON SOLARMODULEN**
METHOD FOR MANUFACTURING PHOTOVOLTAIC MODULES
MÉTHODE POUR LA FABRICATION DE MODULES PHOTOVOLTAÏQUES

(30) Priorität: 07.08.2009 DE 102009036533
(43) Veröffentlichungstag der Anmeldung: 13.06.2012
(73) Patentinhaber: Lanxess Deutschland GmbH, 51369 Leverkusen (DE)
(72) Erfinder: BERGMANN, Gerd, 22523 Hamburg (DE); HERRMANN, Michael, 50829 Köln (DE); KREMERS, Arndt, 52146 Würselen (DE)
(86) Internationale Anmeldenummer: PCT/EP2010/061299
(87) Internationale Veröffentlichungsnummer: WO 2011/015584

(56) Entgegenhaltungen:
- DE-A1-102005 058 014
- JP-A- 7 297 434
- JP-A- 2000 236 104
- US-A1- 2001 009 160
- US-A1- 2006 234 038

## Beschreibung

Die vorliegende Erfindung betrifft ein Verfahren zur Herstellung von Solarmodulen.

Solarmodule setzen sich im Wesentlichen aus einem Verbund aus lichtdurchlässigen Materialien, Solarzellen, stromführenden Bauteilen und witterungsbeständigen Schutzvorrichtungen zusammen. Unterschiedliche Solarmodule, wie Folien-Rückseiten Module, laminierte Glas-Glas-Module, Glas-Glas-Module in Gießharztechnik, Glas-Glas-Module in Verbundsicherheitsfolien-Technologie und Dünnschicht-Module sind dem Fachmann bekannt.

In einem Solarmodul ist die Solarzelle in der Regel beidseitig von polymerem Einbettungsmaterial umgeben. Diese polymeren Einbettungsmaterialien bestehen häufig aus z.B. einem α-Olefin-Vinylacetat-Copolymeren. Auf der Oberseite der Solarzelle befindet sich ein lichtdurchlässiges Substrat, bestehend aus z.B. einem Einscheiben-Sicherheitsglas (ESB). Auf der Unterseite der Solarzelle befindet sich in der Regel eine Schutzschicht, bestehend aus einer witterungsfesten Kunststofffolie.

EP 1 184 912 A1 beschreibt die Herstellung von Solarmodulen, wobei lichtdurchlässige Substrate mit polymeren Einbettungsmaterialien, bestehend aus α-Olefin-Vinylacetat-Copolymeren, Solarzellen, weiteren polymeren Einbettungsmaterialien und einer Schutzschicht übereinander geschichtet und in einem Verfahrensschritt laminiert werden. Weiterhin beschreibt EP 1 184 912 A1, dass ein α-Olefin-Vinylacetat-Copolymer, insbesondere das Ethylen-Vinylacetat-Copolymer (EVA), mit einem hohen Vinylacetat Gehalt besonders klebrig ist und eine exakte Positionierung der Substrate, der Olefin-Vinylacetat-Folie und der Solarzellen zur Herstellung des Solarmoduls schwierig wird. Dieser Effekt wird noch dadurch verstärkt, dass EVA-Copolymere mit einem Vinylacetat-Gehalt ≥ 40 % leicht fließend sind und dadurch den Einbettungsprozess der Solarzellen erschweren. Eine exakte Anordnung der einzelnen Komponenten ist aber extrem wichtig, da ansonsten die Energieeffizienz des Solarmoduls reduziert wird und die Fehlpositionierungen zu Schäden an den Solarzellen führen können. Die dadurch resultierenden fehlerhaften Solarmodule müssten verworfen werden, wodurch zusätzliche Kosten entstehen.

Generell stellt die Positionierung der lichtdurchlässigen Substrate, der polymeren Einbettungsmaterialien, bestehend aus α-Olefin-Vinylacetat-Copolymeren, der Solarzellen, weiterer polymerer Einbettungsmaterialien, bestehend aus α-Olefin-Vinylacetat-Copolymeren, und des lichtundurchlässigen Substrates bei der Herstellung von Solarmodulen ein Problem dar, da die genaue Positionierung dieser fünf Komponenten zueinander aufgrund der Materialeigenschaften, insbesondere der Klebrigkeit und des Handlings häufig zu nicht korrigierbaren Verschiebungen der Komponenten führt und daraus fehlerhafte Solarmodule resultieren.

Aufgabe der vorliegenden Erfindung ist es daher, ein Verfahren zur präzisen und effektiven Herstellung von Solarmodulen bereitzustellen, mit dem die Nachteile des Standes der Technik überwunden werden können.

Es wurde jetzt überraschend gefunden, dass mit dem erfindungsgemäßen Verfahren Solarmodule mit guter Präzision und unter geringem Zeitaufwand, unter Einsatz von separat angefertigten Bauteilen, bestehend aus polymerem Einbettungsmaterial und Substrat, hergestellt werden können.

Gegenstand der Erfindung ist daher ein Verfahren zur Herstellung von Solarmodulen, bei dem
in einem Schritt a)
ein lichtdurchlässiges oder lichtundurchlässiges Substrat mit einem Einbettungsmaterial aus mindestens einem α-Olefin-Vinylacetat-Copolymeren mit einem Vinylacetat-Gehalt von ≥ 40 Gew.-%, bezogen auf das Gesamtgewicht des α-Olefin-Vinylacetat-Copolymers, zu einem Bauteil laminiert wird
und
in einem Schritt b)
ein nach Schritt a) aus lichtdurchlässigem Substrat hergestelltes Bauteil und ein nach Schritt a) aus lichtundurchlässigem Substrat hergestelltes Bauteil mit mindestens einer Solarzelle, die zwischen dem lichtdurchlässigen und dem lichtundurchlässigen Bauteil positioniert ist, zum Solarmodul laminiert werden.

Weitere im Text vorkommende Bezüge auf α-Olefin-Vinylacetat-Copolymere, beziehen sich immer auf α-Olefin-Vinylacetat-Copolymere mit einem Vinylacetat-Gehalt von ≥ 25 Gew.-% bezogen auf das Gesamtgewicht der α-Olefin-Vinylacetat-Copolymere, außer wenn dies explizit anders definiert wurde.

In einer bevorzugten Ausführungsform der Erfindung weist das Einbettungsmaterial mindestens ein Additiv auf.

Das Einbettungsmaterial kann vorzugsweise 1 Gew.% bis 70 Gew.% mindestens eines α-Olefin-Vinylacetat-Copolymers und 0 Gew.% bis 30 Gew. % mindestens eines Additivs, bezogen auf das Gesamtgewicht des Einbettungsmaterials, enthalten. Besonders bevorzugt enthält es 1 Gew.% bis 80 Gew.% mindestens eines α-Olefin-Vinylacetat-Copolymers und 0 Gew.% bis 20 Gew. % mindestens eines Additivs, bezogen auf das Gesamtgewicht des Einbettungsmaterials. Ganz besonders bevorzugt enthält das Einbettungsmaterial 90 Gew.% bis 100 Gew.% mindestens eines α-Olefin-Vinylacetat-Copolymers, und 0 - 10 Gew.% mindestens eines Additivs, jeweils bezogen auf das Gesamtgewicht des Einbettungsmaterials. Die Summe der eingesetzten α-Olefin-Vinylacetat-Copolymers oder/und des/der Additivs(e) beträgt 100 Gew.%, bezogen auf das Gesamtgewicht des Einbettungsmaterials.

Beispielsweise und vorzugsweise kann das Einbettungsmaterial ein, zwei, drei oder mehrere α-Olefin-Vinylacetat-Copolymere bezogen auf das Gesamtgewicht des α-Olefin-Vinylacetat-Copolymers enthalten. Bevorzugt sind Mischungen zweier oder mehrerer verschiedener α-Olefin-Vinylacetat-Copolymere. Besonders bevorzugt ist es jedoch, nur ein α-Olefin-Vinylacetat-Copolymer einzusetzen.

Das Einbettungsmaterial enthält mindestens ein α-Olefin-Vinylacetat-Copolymer mit Vinylacetat-Copolymer-Gehalten von ≥ 40 Gew.-%, besonders bevorzugt Vinylacetatgehalte von ≥ 45 Gew.-%, jeweils bezogen auf das Gesamtgewicht der α-Olefin-Vinylacetat-Copolymere. Üblicherweise beträgt der Vinylacetat-Gehalt der eingesetzten α-Olefin-Vinylacetat-Copolymere ≥ 40 Gew.-% bis 98 Gew.-%, besonders bevorzugt ≥ 45 Gew.-% bis 98 Gew.-% und der α-Olefin-Gehalt 2 Gew.-% bis ≤ 75 Gew.-%, bevorzugt 2 Gew.-% bis ≤ 60 Gew.-%, besonders bevorzugt 2 Gew.-% bis ≤ 55 Gew.-%, wobei die Gesamtmenge an Vinylacetat und α-Olefin 100 Gew.-% beträgt.

Als α-Olefine können in dem, im Einbettungsmaterial eingesetzten α-Olefin-Vinylacetat-Copolymer alle bekannten α-Olefine eingesetzt werden. Bevorzugt ist das α-Olefin ausgewählt aus Ethen, Propen, Buten, insbesondere n-Buten und i-Buten, Penten, Hexen, insbesondere 1-Hexen, Hepten und Octen, insbesondere 1-Octen. Es können auch höhere Homologe der genannten α-Olefine als α-Olefine in den im Einbettungsmaterial eingesetztem α-Olefin-Vinylacetat-Copolymeren eingesetzt werden. Die α-Olefine können des Weiteren Substituenten tragen, insbesondere C₁-C₅-Alkylreste. Bevorzugt tragen die α-Olefine jedoch keine weiteren Substituenten.

Bevorzugte α-Olefine sind Ethen und Propen, wobei Ethen besonders bevorzugt als α-Olefin in den im Einbettungsmaterial eingesetzten α-Olefin-Vinylacetat-Copolymeren eingesetzt wird. Somit handelt es sich bei dem bevorzugt in dem erfindungsgemäßen Bauteil eingesetzten α-Olefin-Vinylacetat-Copolymer um ein Ethylen-Vinylacetat-Copolymer.

Besonders bevorzugt wird als Einbettungsmaterial ausschließlich ein Ethylen-Vinylacetat-Copolymer eingesetzt. Dieses weist dann einen Vinylacetat-Gehalt von ≥ 40 Gew.-% bis 98 Gew.-%, besonders bevorzugt ≥ 45 Gew.-% bis 98 Gew.-% und einen Ethylen-Gehalt von 2 Gew.-% bis ≤ 60 Gew.-%, besonders bevorzugt 2 Gew.-% bis ≤ 55 Gew.-% auf.

Beispielsweise und vorzugsweise sind die Additive ausgewählt aus der Gruppe Peroxide, Lichtstabilisatoren, Silane, Alterungsschutzmittel, Photoinitiatoren wie Benzophenone sowie Coagenzien zur Erhöhung der Vernetzungsdichte wie Triallylcyanurat oder Triallyisocyanurat oder aus Mischungen aus diesen Materialien.

Geeignete Herstellungsverfahren für α-Olefin-Vinylacetat-Copolymere sind in EP-A 0 341 499, EP-A 0 510 478 und DE-A 38 25 450 genannt.

Die im erfindungsgemäßen Verfahren bevorzugt eingesetzten α-Olefin-Vinylacetat-Copolymere mit einem Vinylacetat-Gehalt von ≥ 40 Gew.-%, werden nach einem aus DE 2 031 662 A2 bekannten Lösungspolymerisations-Verfahren hergestellt.

Die im erfindungsgemäßen Verfahren eingesetzten α-Olefin-Vinylacetat-Copolymere, bevorzugt Ethylen-Vinylacetat-Copolymere mit einem Vinylacetat-Gehalt von ≥ 40 Gew.-%, weisen im Allgemeinen MFI-Werte (g/10 min), gemessen nach ISO 1133 bei 190 °C und einer Last von 21,1 N, von 1 bis 40, bevorzugt 1 bis 35, besonders bevorzugt 2 bis 6, auf.

Die Mooney-Viskositäten der in dem im erfindungsgemäßen Verfahren eingesetzten α-Olefin-Vinylacetat-Copolymere betragen gemäß DIN 53523 ML 1+4 bei 100 °C in der Regel 3 bis 50, bevorzugt 4 bis 35 Mooney-Einheiten.

Das zahlenmittlere durchschnittliche Molekulargewicht der in dem im erfindungsgemäßen Verfahren eingesetzten α-Olefin-Vinylacetat-Copolymere beträgt, bestimmt mittels GPC (Gel-Permeations-Chromatographie), beispielsweise von 5000 g/mol bis 200000 g/mol, bevorzugt 10000 g/mol bis 100000 g/mol.

Besonders bevorzugt werden in dem erfindungsgemäßen Verfahren zur Herstellung von Solarmodulen Ethylen-Vinylacetat-Copolymere eingesetzt, die zum Beispiel unter den Handelnamen Levapren^{®} oder Levamelt^{®} bei der Lanxess Deutschland GmbH kommerziell erhältlich sind.

Besonders bevorzugt werden in dem erfindungsgemäßen Verfahren zur Herstellung von Solarmodulen als Ethylen-Vinylacetat-Copolymere Levamelt 450, Levamelt 452, Levamelt 456, Levamelt 500, Levamelt^{®} 600, Levamelt 686, Levamelt^{®} 700, Levamelt^{®} 800 und Levamelt^{®} 900 mit 45±2 Gew. % Vinylacetat und einem MFI-Wert zwischen 1 - 5, 45±2 Gew. % Vinylacetat mit einem MFI-Wert von 5 bis 15, 45±2 Gew. % Vinylacetat mit einem MFI-Wert zwischen 15 - 35, 50±2 Gew. % Vinylacetat, 60±2 Gew.-% Vinylacetat, 68 ±2 Gew.% Vinylacetat mit einem MFI-Wert zwischen 15 - 35, 70±2 Gew.-% Vinylacetat, 80±2 Gew.-% Vinylacetat bzw. 90±2 Gew.-% Vinylacetat, eingesetzt.

Bei dem Substrat kann es sich um Glas, Polycarbonat, Polyester, Polyvinylfluorid, Polyvinylfluorid Polymer Laminate, Polyvinylidenfluorid oder Polyethylenterephthalat oder um Mischungen aus diesen Materialien handeln. Einige dieser Polymeren können je nach Zusammensetzung und Verarbeitung lichtdurchlässige oder/und lichtundurchlässige Eigenschaften aufweisen. Die Herstellung dieser Polymere und deren Eigenschaften sind dem Fachmann bekannt.

Ein lichtdurchlässiges Substrat wird vorzugsweise dann in dem Bauteil eingesetzt, wenn dieses Bauteil auf der der Sonne zugewandten Seite angebracht wird. Es sind alle dem Fachmann bekannten lichtdurchlässigen Substrate, wie z.B. und vorzugsweise Glas, Polycarbonat, Polyester, Polyvinylfluorid, Polyvinylidenfluorid, Polyethylenterephthalat oder Mischungen aus diesen Materialien geeignet. Bevorzugt handelt es sich bei den lichtdurchlässigen Materialien um Glas,

Polyvinylfluorid Polymer Laminate und Polyethylenterephthalat. Als lichtdurchlässiges Substrat sind besonders bevorzugt Glasscheiben geeignet, wobei ganz besonders bevorzugt ein so genanntes Einscheiben-Sicherheits-Glas (ESG) eingesetzt wird.

Ein lichtundurchlässiges Substrat wird vorzugsweise dann in dem Bauteil eingesetzt, wenn dieses Bauteil auf der Unterseite des Solarmoduls, d.h. auf der, der Sonne abgewandten Seite angebracht wird. Bevorzugt handelt es sich bei dem lichtundurchlässigen Substrat um Polyester, Polyvinylfluorid, Polyvinylidenfluorid oder Polyethylenterephthalat. Besonders bevorzugt handelt es sich bei dem lichtundurchlässigen Substrat um eine Kunststofffolie, insbesondere eine Kunststoffverbundfolie, zum Beispiel aufgebaut aus Polyvinylfluorid, z.B. Tedlar^{®} von DuPont, Polyester, Polyvinylidenfluorid, z.B. Kynar^{®} von der Fa. Arkema oder um Polyethylenterephthalat.

Die Oberfläche des lichtundurchlässigen Substrats kann z.B. auch chemisch behandelt sein, um besser mit dem Einbettungsmaterial verbunden werden zu können. Vorzugsweise ist die Oberfläche des lichtundurchlässigen Substrats mittels Plasmen, insbesondere mit Sauerstoffplasmen behandelt worden. Besonders bevorzugt wird das lichtundurchlässige Substrat dann behandelt, wenn das lichtundurchlässige Substrat unbehandelt schlecht haftet.

Vorzugsweise dient das auf der Unterseite des Solarmoduls aufgebrachte lichtundurchlässige Substrat als witterungsfeste Schutzschicht, die die Rückseite des Solarmoduls bildet (Rückseitenkaschierung).

Als Solarzellen sind alle dem Fachmann bekannten Solarzellen geeignet. Geeignete Solarzellen sind beispielsweise Siliziumzellen, wobei es sich um Dickschichtzellen (mono- oder polykristalline Zellen) oder Dünnschichtzellen (amorphes Silizium oder kristallines Silizium) handeln kann; III-V-Halbleiter Solarzellen (Ga-As-Zellen); II-VI-Halbleiter Solarzellen (CdTe-Zellen); CIS-Zellen (Kupfer-Indium-Diselenid oder Kupfer-Indium-Disulfid) oder CIGS-Zellen (Kupfer-Indium-Gallium-Diselenid); organische Solarzellen, Farbstoffzellen (Grätzel-Zellen) oder Halbleiter-Elektrolytzellen (z. B. Kupferoxid/NaCl-Lösung); wobei Siliziumzellen bevorzugt eingesetzt werden. Dabei können alle dem Fachmann bekannten Typen von Siliziumzellen eingesetzt werden, z. B. monokristalline Zellen, polykristalline Zellen, amorphe Zellen, mikrokristalline Zellen oder Tandem-Solarzellen, die z. B. aus einer Kombination von polykristallinen und amorphen Zellen aufgebaut sind. Bevorzugt werden polykristalline und amorphe Zellen eingesetzt.

Die Strukturen der vorstehend genannten Solarzellen sind dem Fachmann bekannt.

Neben Dickschichtzellen können Dünnschichtzellen, Konzentratorzellen, elektrochemische Farbstoff-Solarzellen, organische Solarzellen oder Fluoreszenz-Zellen eingesetzt werden. Zudem können flexible Solarzellen eingesetzt werden.

Geeignete Verfahren zur Herstellung der Solarzellen sind dem Fachmann bekannt.

Im Rahmen des Schrittes a) des erfindungsgemäßen Verfahrens werden die Einbettungsmaterialien bevorzugt unabhängig voneinander mit den lichtdurchlässigen Substraten oder den lichtundurchlässigen Substraten zu einem lichtdurchlässigen oder/und lichtundurchlässigen Bauteil laminiert. Vorzugsweise wird im Schritt a) des erfindungsgemäßen Verfahrens so vorgegangen, dass das vorzugsweise gereinigte lichtdurchlässige oder/und lichtundurchlässige Substrat vorgelegt wird. Das Einbettungsmaterial wird im Allgemeinen nach den dem Fachmann bekannten Verfahren, wie z.B. durch Co-Extrusion, Extrusion (Cast-Extrusion, Flachfilmextrusion) oder Kalandrierung, hergestellt und als Folie auf das lichtdurchlässige oder/und lichtundurchlässige Substrat aufgegeben. Gegebenenfalls wird das Einbettungsmaterial zugeschnitten und auf dem Substrat positioniert. Danach erfolgt die Laminierung beispielsweise nach dem Fachmann bekannten Verfahren, wie z.B. der Standard-Vakuum Laminierung. Bei der Laminierung bildet das Einbettungsmaterial eine transparente Polymerschicht auf dem lichtdurchlässigen oder/und lichtundurchlässige Substrat aus, die fest mit dem Substrat verbunden ist. Diese transparente Polymerschicht weist beispielsweise eine Dicke von 1 µm bis 1000 µm auf. Bevorzugt weist die transparente Polymerschicht nach der Laminierung in Schritt a) des erfindungsgemäßen Verfahrens eine Dicke von 100 µm bis 700 µm, besonders bevorzugt von 200 µm bis 500 µm auf.

Die Laminierung im Rahmen des Schrittes a) des erfindungsgemäßen Verfahrens kann z.B. bei Temperaturen von 140 bis 220 °C durchgeführt werden. Bevorzugt erfolgt die Laminierung aus Schritt a) des erfindungsgemäßen Verfahrens bei einer Temperatur von 150 °C bis 210 °C, besonders bevorzugt bei einer Temperatur von 160 °C bis 180 °C.

Beispielsweise kann das lichtdurchlässige oder/und lichtundurchlässige Substrat mit dem Einbettungsmaterial vollständig umgeben sein. Das Einbettungsmaterial kann aber auch nur auf der Oberseite oder der Unterseite des lichtdurchlässigen Substrates oder/und des lichtundurchlässigen Substrates aufgebracht werden. Bevorzugt wird das Einbettungsmaterial in Schritt a) des erfindungsgemäßen Verfahrens lediglich auf einer Seite des lichtdurchlässigen Substrates oder/und des lichtundurchlässigen Substrates aufgebracht.

Schritt b) des erfindungsgemäßen Verfahrens wird vorzugsweise so durchgeführt, dass die in Schritt a) des erfindungsgemäßen Verfahrens hergestellten Bauteile nacheinander mit mindestens einer Solarzelle in Kontakt gebracht werden. Beispielsweise kann zunächst das in Schritt a) des erfindungsgemäßen Verfahrens hergestellte lichtdurchlässige Bauteil vorgelegt werden. Die Solarzellen befinden sich zwischen den transparenten Polymermaterialen der lichtdurchlässigen und lichtundurchlässigen Bauteile. Die Positionierung der Solarzelle kann z.B. automatisch mittels Roboter oder manuell erfolgen. Danach können die lichtdurchlässigen und lichtundurchlässigen Bauteile und mindestens eine Solarzelle laminiert werden.

Es können aber ebenfalls zunächst die Solarzellen auf das transparente Polymermaterial des in Schritt a) des erfindungsgemäßen Verfahrens hergestellten lichtundurchlässigen Bauteils aufgebracht werden. Auf die dann noch unbedeckte Oberfläche des Solarmoduls kann dann das transparente Polymermaterial des in Schritt a) des erfindungsgemäßen Verfahrens hergestellten lichtdurchlässigen Bauteils, aufgebracht werden. Danach könnten dann die lichtdurchlässigen und lichtundurchlässigen Bauteile und mindestens eine Solarzelle laminiert werden. Bevorzugt wird zunächst das im Schritt a) des erfindungsgemäßen Verfahrens hergestellte lichtdurchlässige Bauteil vorgelegt. Darauf werden dann die Solarzellen auf das transparente Polymermaterial, bevorzugt automatisiert mittels Roboter, positioniert. Bevorzugt wird darauf dann das lichtundurchlässige Bauteil mit der Seite aufgebracht, auf der sich das transparente Polymermaterial befindet. Bevorzugt erfolgt dann die Laminierung zum Verbund.

In einer Ausführungsform der Erfindung enthält das Solarmodul mehrer Solarzellen, die dann mittels Lötbändchen miteinander zu sog. Strängen verbunden werden. Mehrere Stränge werden häufig mittels Querverbinder miteinander in Verbindung gebracht. In einer bevorzugten Ausführungsform des erfindungsgemäßen Verfahrens werden die Solarzellen vor dem in Kontakt bringen mit einem in Schritt a) des erfindungsgemäßen Verfahrens hergestellten Bauteils mittels so genannter Lötbändchen zu einzelnen Strängen (strings) verbunden. Bevorzugt werden die Solarzellen vor dem in Kontakt bringen mit dem lichtdurchlässigen Bauteil mittels der Lötbändchen verbunden. Vorzugsweise werden anschließend Querverbinder, die die einzelnen Stränge miteinander verbinden und zu einer Anschlussdose führen, positioniert und in Kontakt gebracht. Dann wird das lichtundurchlässige, in Schritt a) des erfindungsgemäßen Verfahrens hergestellte Bauteil mit der Seite auf dem Solarmodul aufgebracht, auf der sich das transparente Polymermaterial befindet. Die Positionierung kann z.B. automatisch und vorzugsweise mittels Roboter erfolgen. Dann erfolgt vorzugsweise die Laminierung zum Verbund.

Die Laminierung nach Schritt b) des erfindungsgemäßen Verfahrens erfolgt vorzugsweise bei Temperaturen von 140°C bis 220°C, bevorzugt bei Temperaturen von 150°C bis 210°C und ganz besonders bevorzugt bei Temperaturen von 160 °C bis 180 °C.

Die Laminierung nach Schritt a) und/oder Schritt b) des erfindungsgemäßen Verfahrens erfolgt mittels Druck oder/und Hitze nach den dem Fachmann bekannten Verfahren wie z.B. der Standard-Vakuum Laminierung. Bevorzugt erfolgt die Laminierung nach Schritt a) und/oder Schritt b) des erfindungsgemäßen Verfahrens mittels Hitze bei Unterdruck.

Durch die Laminierung nach Schritt b) des erfindungsgemäßen Verfahrens wird erreicht, dass die Solarzellen in die transparente Polymerschicht eingebettet werden und fest mit dem lichtdurchlässigen Substrat und dem lichtundurchlässigen Substrat verbunden werden. Anschließend wird vorzugsweise eine Anschlussdose gesetzt und das Solarmodul mit Hilfe z.B. eines Aluminiumrahmens gerahmt.

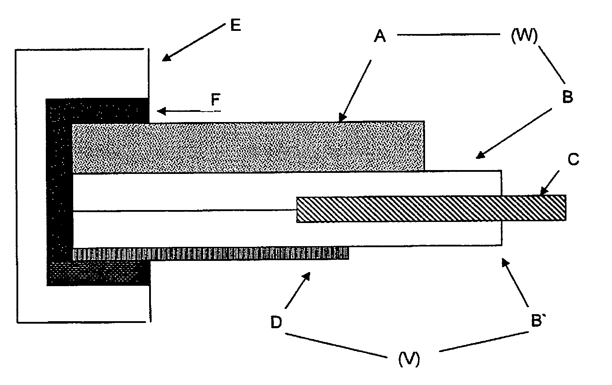

Beispielsweise und vorzugsweise weisen die im Rahmen des erfindungsgemäßen Verfahrens hergestellten Solarmodule folgenden Aufbau auf (siehe auch Figur 1/1):
i) Bauteil (W), bestehend aus einem lichtdurchlässigen Substrat A mit einer Vorder- und Rückseite, wobei die Vorderseite die in dem fertigen Solarmodul zur Sonne gewandte Seite ist, und einer auf die Rückseite des lichtdurchlässigen Substrats aufgebrachten transparenten Polymerschicht B;
ii) eine oder mehrere zwischen den transparenten Polymerschichten B und B' positionierte Solarzelle C;
iii) Bauteil (V), bestehend aus einem lichtundurchlässigen Substrat D, wobei das lichtundurchlässige Substrat D in dem fertigen Solarmodul über die transparente Polymerschicht B' mit den/der Solarzelle(n) C verbunden ist.

Die Solarzellen C sind besonders bevorzugt in die transparenten Polymerschichten B und/oder B' eingebettet.

Die transparenten Polymerschichten B und/oder B' entstehen bei der Laminierung des Einbettungsmaterials mit dem Substrat in Schritt a) des erfindungsgemäßen Verfahrens.

Besonders geeignete Polymerschichten B und B' bestehen aus Ethylen-Vinylacetat-Copolymere mit einem Vinylacetat-Gehalt von ≥ 40 Gew. %.

Beispielsweise und vorzugsweise werden durch das erfindungsgemäße Verfahren in Schritt a) die Bauteile (W) und (V) hergestellt. Bevorzugt wird Bauteil (W) durch Laminierung einer Seite eines lichtdurchlässigen Substrates A mit dem Einbettungsmaterial, bestehend aus mindestens einem α-Olefin-Vinylacetat-Copolymer hergestellt, wodurch aus dem Einbettungsmaterial die transparente Polymerschicht wird. Bevorzugt wird Bauteil (V) durch Laminierung von einem lichtundurchlässigen Substrat D, besonders bevorzugt einer witterungsfesten Schutzschicht, mit dem Einbettungsmaterial, bestehend aus mindestens einem α-Olefin-Vinylacetat-Copolymer nach Schritt a) des erfindungsgemäßen Verfahrens, hergestellt. Durch diesen Schritt entsteht aus dem Einbettungsmaterial die transparente Polymerschicht. Besonders bevorzugt wird bei der Herstellung der Bauteile (W) und (V) nach Schritt a) des erfindungsgemäßen Verfahrens ein Ethylen-Vinylacetat-Copolymer mit einem Vinylacetat-Gehalt ≥ 40 Gew.-% eingesetzt.

Bevorzugt wird das lichtdurchlässige Substrat A mit dem Einbettungsmaterial so zu dem neuen Bauteil (W) laminiert, das die transparente Polymerschicht B auf dem lichtdurchlässigen Substrat A auf der Unterseite, also der Seite, die den Solarzellen zugewendet ist, aufgebracht ist. Bevorzugt wird das lichtundurchlässige Substrat D so mit dem Einbettungsmaterial zu dem neuen Bauteil (V) laminiert, dass das lichtundurchlässige Substrat D auf der Seite, die den Solarzellen zugewendet ist, mit dem transparenten Polymermaterial B' beschichtet ist.

Bevorzugt werden auf das im Schritt a) des erfindungsgemäßen Verfahrens hergestellte Bauteil (W) die Solarzellen auf der Unterseite aufgebracht. Diese werden vorzugsweise zunächst mittels so genannter Lötbändchen miteinander verbunden und dann positioniert. Danach wird das Bauteil (V) mit der Seite aufgebracht, auf der sich das transparente Polymermaterial B' befindet. Vorzugsweise werden anschließend Querverbinder, die die einzelnen Stränge miteinander verbinden und zu einer Anschlussdose führen, positioniert und in Kontakt gebracht. Die Positionierungen erfolgen automatisch mittels Roboter. Dann erfolgt die Laminierung nach Schritt b) des erfindungsgemäßen Verfahrens. Danach können gegebenenfalls weitere dem Fachmann bekannte Bauteile, wie z.B. Dichtungen, Aluminiumprofil-Rahmen und elektrische Anschlussterminals an das Solarmodul angebracht werden. Diese Bauteile sowie deren Einbau sind dem Fachmann bekannt.

Das erfindungsgemäße Verfahren kann auch zur Herstellung von Solarmodulen dienen, die einen anderen Aufbau als den vorstehend genannten bevorzugten Aufbau aufweisen. Beispiele sind Glas-Glas Module, Konzentrator-Module, worin das Sonnenlicht mit Hilfe einer Optik auf kleinere Solarzellen konzentriert wird, sowie Fluoreszenzkollektoren.

Das erfindungsgemäße Verfahren weist den Vorteil auf, dass Solarmodule effizient hergestellt werden, da Bauteile effizienter fixiert und laminiert werden können und dadurch die Anzahl fehlerhaft produzierter Solarmodule reduziert wird.

In Figur 1 ist ein Beispiel für ein nach dem erfindungsgemäßen Verfahren hergestelltes Solarmodul dargestellt.

In Figur 1 bedeuten:
Bauteil (W)
   A lichtdurchlässiges Substrat
   B transparentes Polymermaterial, aufgebaut aus mindestens einem α-Olefin-Vinylacetat-Copolymeren und gegebenenfalls weiteren Additiven, bevorzugt einem Ethylen-Vinylacetat-Copolymeren, besonders bevorzugt einem Ethylen-Vinylacetat-Copolymeren mit der Bezeichnung Levamelt^{®} von Lanxess Deutschland GmbH;
   C Solarzellen;
Bauteil (V)
   B transparentes Polymermaterial, aufgebaut aus mindestens einem α-Olefin-Vinylacetat-Copolymeren und gegebenenfalls weiteren Additiven, bevorzugt einem Ethylen-Vinylacetat-Copolymeren, bevorzugt einem Ethylen-Vinylacetat-Copolymeren mit der Bezeichnung Levamelt^{®} von Lanxess Deutschland GmbH;
   D lichtundurchlässiges Substrat bzw. Schutzschicht;
   E Rahmen, bevorzugt ein Aluminiumprofil-Rahmen;
   F Dichtung.
Bauteil (W) umfasst die Komponenten A und B. Bauteil (V) umfasst die Komponenten B' und D. Es können mit dem erfindungsgemäßen Verfahren auch Solarmodule hergestellt werden, die keine Komponenten E und F aufweisen. Insbesondere kann die Komponente E bei flexiblen Solarmodulen entfallen.

Geeignete Komponenten A, B, B', C, D und E wurden bereits vorstehend näher beschrieben. Geeignete Dichtungen F sind dem Fachmann bekannt.

## Patentansprüche

1. Verfahren zur Herstellung von Solarmodulen, **dadurch gekennzeichnet, dass**
in einem Schritt a)
ein lichtdurchlässiges oder lichtundurchlässiges Substrat mit einem Einbettungsmaterial aus mindestens einem α-Olefin-Vinylacetat-Copolymeren mit einem Vinylacetat-Gehalt von ≥ 40 Gew.-%, bezogen auf das Gesamtgewicht des α-Olefin-Vinylacetat-Copolymers, zu einem Bauteil laminiert wird
und
in einem Schritt b)
ein nach Schritt a) aus lichtdurchlässigem Substrat hergestelltes Bauteil und ein nach Schritt a) aus lichtundurchlässigem Substrat hergestelltes Bauteil mit mindestens einer Solarzelle, die zwischen dem lichtdurchlässigen und dem lichtundurchlässigen Bauteil positioniert ist, zum Solarmodul laminiert werden, wobei die Laminierung in Schritt a) oder/und in Schritt b) bei Temperaturen von 140 °C bis 220 °C durchgeführt wird

2. Verfahren nach Anspruch 1, **dadurch gekennzeichnet, dass** das Einbettungsmaterial mindestens ein Additiv enthält.

3. Verfahren zur Herstellung von Solarmodulen nach Anspruch 1 oder 2, **dadurch gekennzeichnet, dass** das Einbettungsmaterial ein α-Olefin-Vinylacetat-Copolymeren mit 90 Gew.-% bis 100 Gew.-% und 10 bis 0 Gew.-% eines Additivs, bezogen auf das Gesamtgewicht des Einbettungsmaterials enthält.

4. Verfahren zur Herstellung von Solarmodulen nach einem der Ansprüche 1 bis 3, **dadurch gekennzeichnet**, das das Einbettungsmaterial das Additiv mit 0 Gew.-% bis 20 Gew.- %, bezogen auf das Gesamtgewicht des Einbettungsmaterials, enthält.

5. Verfahren zur Herstellung von Solarmodulen nach einem der Ansprüche 1 bis 4, **dadurch gekennzeichnet, dass** die Additive ausgewählt sind aus der Gruppe Peroxide, Lichtstabilisatoren, Silane, Alterungsschutzmittel, Benzophenone, Triallylcyanurat oder Triallyisocyanurat oder aus Mischungen dieser Additive.

6. Verfahren zur Herstellung von Solarmodulen nach einem der Ansprüche 1 bis 5, **dadurch gekennzeichnet, dass** als lichtdurchlässiges Substrat Glas, Polyvinylfluorid Polymer Laminate oder Polyethylenterephthalat oder Mischungen dieser Materialien eingesetzt wird.

7. Verfahren zur Herstellung von Solarmodulen nach einem der Ansprüche 1 bis 6, **dadurch gekennzeichnet, dass** als lichtundurchlässiges Substrat Polyester, Polyvinylidenfluorid oder Polyethylenterephthalat oder Mischungen dieser Materialien eingesetzt wird.

8. Verfahren zur Herstellung von Solarmodulen nach einem der Ansprüche 1 bis 7, **dadurch gekennzeichnet, dass** das Einbettungsmaterial nach der Laminierung im Schritt a) nach Anspruch 1 eine Dicke zwischen 200 µm bis 500 µm auf dem Substrat aufweist.

9. Verfahren zur Herstellung von Solarmodulen nach einem der Ansprüche 1 bis 8, **dadurch gekennzeichnet, dass** die Laminierung in Schritt a) oder/und in Schritt b) bei Temperaturen von 160 °C bis 180 °C durchgeführt wird.

## Claims

1. Process for producing solar modules, **characterized in that**,
in a step a),
a transparent or opaque substrate is laminated with an embedding material composed of at least one α-olefin-vinyl acetate copolymer having a vinyl acetate content of ≥ 40% by weight, based on the total weight of the α-olefin-vinyl acetate copolymer, to give a component
and,
in a step b),
a component produced from transparent substrate in step a) and a component produced from opaque substrate in step a) are laminated with at least one solar cell positioned between the transparent and the opaque component to give the solar module, the lamination in step a) or/and in step b) being performed at temperatures of 140°C to 220°C.

2. Process according to Claim 1, **characterized in that** the embedding material comprises at least one additive.

3. Process for producing solar modules according to Claim 1 or 2, **characterized in that** the embedding material comprises an α-olefin-vinyl acetate copolymer at 90% by weight to 100% by weight and 10 to 0% by weight of an additive, based on the total weight of the embedding material.

4. Process for producing solar modules according to any of Claims 1 to 3, **characterized in that** the embedding material contains the additive at 0% by weight to 20% by weight, based on the total weight of the embedding material.

5. Process for producing solar modules according to any of Claims 1 to 4, **characterized in that** the additives are selected from the group of peroxides, light stabilizers, silanes, aging stabilizers, benzophenones, triallyl cyanurate or triallyl isocyanurate, or from mixtures of these additives.

6. Process for producing solar modules according to any of Claims 1 to 5, **characterized in that** the transparent substrate used is glass, polyvinyl fluoride polymer laminates or polyethylene terephthalate, or mixtures of these materials.

7. Process for producing solar modules according to any of Claims 1 to 6, **characterized in that** the opaque substrate used is polyester, polyvinylidene fluoride or polyethylene terephthalate, or mixtures of these materials.

8. Process for producing solar modules according to any of Claims 1 to 7, **characterized in that** the embedding material after the lamination in step a) according to Claim 1 has a thickness between 200 µm and 500 µm on the substrate.

9. Process for producing solar modules according to any of Claims 1 to 8, **characterized in that** the lamination in step a) or/and in step b) is performed at temperatures of 160°C to 180°C.

## Revendications

1. Procédé de fabrication de modules solaires, **caractérisé en ce que**
lors d'une étape a)
un substrat translucide ou opaque est stratifié avec un matériau d'enrobage constitué d'au moins un copolymère d'α-oléfine-acétate de vinyle ayant une teneur en acétate de vinyle ≥ 40 % en poids, par rapport au poids total du copolymère d'α-oléfine-acétate de vinyle, pour former un composant
et
lors d'une étape b)
un composant fabriqué selon l'étape a) à partir d'un substrat translucide et un composant fabriqué selon l'étape a) à partir d'un substrat opaque sont stratifiés avec au moins une cellule solaire, qui est positionnée entre le composant translucide et le composant opaque, pour former un module solaire, la stratification à l'étape a) et/ou à l'étape b) étant réalisée à des températures de 140 °C à 220 °C.

2. Procédé selon la revendication 1, **caractérisé en ce que** le matériau d'enrobage contient au moins un additif.

3. Procédé de fabrication de modules solaires selon la revendication 1 ou 2, **caractérisé en ce que** le matériau d'enrobage contient un copolymère d'α-oléfine-acétate de vinyle à hauteur de 90 % en poids à 100 % en poids et 10 à 0 % en poids d'un additif, par rapport au poids total du matériau d'enrobage.

4. Procédé de fabrication de modules solaires selon l'une quelconque des revendications 1 à 3, **caractérisé en ce que** le matériau d'enrobage contient l'additif à hauteur de 0 % en poids à 20 % en poids, par rapport au poids total du matériau d'enrobage.

5. Procédé de fabrication de modules solaires selon l'une quelconque des revendications 1 à 4, **caractérisé en ce que** les additifs sont choisis dans le groupe constitué par les peroxydes, 1 les photostabilisateurs, les silanes, les agents antivieillissement, les benzophénones, le cyanurate de triallyle ou l'isocyanurate de triallyle ou des mélanges de ces additifs.

6. Procédé de fabrication de modules solaires selon l'une quelconque des revendications 1 à 5, **caractérisé en ce que** du verre, des stratifiés polyfluorure de vinyle-polymère ou du polyéthylène téréphtalate ou des mélanges de ces matériaux sont utilisés en tant que substrat translucide.

7. Procédé de fabrication de modules solaires selon l'une quelconque des revendications 1 à 6, **caractérisé en ce que** du polyester, du polyfluorure de vinylidène ou du polyéthylène téréphtalate ou des mélanges de ces matériaux sont utilisés en tant que substrat opaque.

8. Procédé de fabrication de modules solaires selon l'une quelconque des revendications 1 à 7, **caractérisé en ce que** le matériau d'enrobage présente après la stratification à l'étape a) selon la revendication 1 une épaisseur comprise entre 200 *µ*m et 500 *µ*m sur le substrat.

9. Procédé de fabrication de modules solaires selon l'une quelconque des revendications 1 à 8, **caractérisé en ce que** la stratification à l'étape a) et/ou à l'étape b) est réalisée à des températures de 160 °C à 180 °C.
